# EUROPEAN PATENT SPECIFICATION

(11) **EP 3 806 328 B1**
(45) Date of publication and mention of the grant of the patent: **17.08.2022**
(21) Application number: 19201992.5
(22) Date of filing: 08.10.2019
(51) Int. Cl.: H03K 5/24, H03F 1/08, H03F 3/45, H03M 1/56, H04N 5/378

(54) **COMPARATOR DEVICE FOR COMPARING AN ANALOG SIGNAL WITH A REFERENCE SIGNAL**
KOMPARATORVORRICHTUNG ZUM VERGLEICHEN EINES ANALOGEN SIGNALS MIT EINEM REFERENZSIGNAL
DISPOSITIF COMPARATEUR POUR COMPARER UN SIGNAL ANALOGIQUE À UN SIGNAL DE RÉFÉRENCE

(43) Date of publication of application: 14.04.2021
(73) Proprietor: Photolitics OOD, 7000 Ruse (BG)
(72) Inventor: WÄNY, Martin, 1025 St. Sulpice (CH)
(74) Representative: IPLodge bv

(56) References cited:
- EP-A2- 2 627 078
- US-A1- 2005 189 992
- US-A1- 2007 216 564
- US-A1- 2016 336 949

## Description

### Field of the disclosure

The present disclosure relates to a comparator device for comparing an analog signal with a reference signal. More specifically it is related to a comparator for an analog-to-digital converter.

### Background

Comparators are widely used for data conversion. Data converters are for example commonly used in image sensors where analog signals from the pixels of the image sensors are read out and converted to digital signals. These conversion systems make use of a plurality of analog-to-digital (ADC) converters and each ADC has a comparator configured to compare a reference signal with an analog input signal as detected by a pixel of the image sensor.

The reference signal is typically a ramp signal generated by a ramp signal generator and the same ramp signal is distributed to the plurality of ADC's. Each of the comparators of the ADC comprises a comparator circuit comparing the analog signal with the reference signal. Typically, the comparator circuit comprises a differential amplifier wherein a first branch is receiving the reference signal as input and a second branch is receiving the analog signal as input.

A known problem with comparators is that when in operation, the reference input signal can become disturbed. This disturbance of the reference signal is generally a consequence of a variation of an input load to the reference signal, i.e. the load as seen by the reference signal is varying. Such a variation of the input load is generally caused by a variation of the bias current in an input transistor of the first branch of the differential amplifier. Indeed, such a variation of the bias current is coupled to the input of the comparator by a parasitic capacitance between for example the drain and gate of the input transistor. This disturbance of reference signal is sometimes named kickback noise.

The impact of the operation of the comparator on the input reference signal is of high importance and this impact should be reduced as much as possible. Particularly, it is not desirable that the comparator changes its input load when it is taking a decision or generates a kick back signal to a reference voltage as this behaviour may negatively influence the quality of the data conversion. Such change of the input load or kick back may affect the data converters linearity or may lead to DNL errors. Even more sensitive are vector type data converters where many comparators are operated in parallel to convert multiple signals. In such a case the change of the input capacitance of a comparator or the fact that it generates a kick back signal to a reference when it takes as decision while converting may influence the conversion result of other signals which use other comparators sharing the common reference signal. This type of cross talk over the common reference voltages can then result in undesired data cross talk between different signals converted in parallel.

In patent US9041581 a comparator device is proposed which minimizes the change of input load to a reference signal. The proposed solution is based on providing a feedback control loop for the current source biasing the differential amplifier. However, this solution has a number of shortcomings. Firstly, the solution only works in the case of single slope AD converters, where the reference voltage gradually increases, or decreases, until crossing the signal value. Secondly the feedback loop needs to be designed to be stable, i.e. free from oscillations. Finally, this solution in patent US9041581 changes the bias current through the input transistor along the comparison and thus the comparator bandwidth, which is undesirable in the case the comparator needs to be operated in a unity gain feedback configuration in order to sample and correct for the comparators input offset. Further, the change in current through the input device during the comparison limits the freedom in sizing the input transistor as the device needs to be in saturation over a much wider range of currents as in a comparator design without such feedback.

Therefore, there is a need for improving comparators and for providing an alternative solution for solving the problem of the variation of the input load to the reference signal.

Patent application EP2627078A2 discloses an image sensing device comprising a reference signal generator for generating a plurality of reference signals and a comparator configured for selecting one of the plurality of reference signals. A connecting unit is connecting the selected reference signal with the input of the comparator and connecting a load element with a non-selected reference signal line, wherein a load of the load element corresponds to the load of the input of the comparator.

Patent application US2007/0216564A1 discloses an analog to digital converter comprising a plurality of differential comparators. The converter comprises a module for applying a voltage signal in the same waveform as that of the reference signal to a back gate terminal of a differential pair transistors of the differential amplifier. In this way, a back-bias effect of transistor can be eliminated.

Patent application US2016/0336949A1 discloses a comparator circuit comprising a comparator and an isolation buffer coupled to an input terminal of the comparator, and wherein the isolation buffer maintains a substantially constant capacitive load on a voltage ramp. The document further discloses a ramp disconnect feature to increase the circuits input range, and a dummy capacitor for maintaining a constant capacitance on the voltage ramp.

Patent document US2005/0189992A1 discloses a bipolar differential input stage with an input bias current cancellation circuit. This cancellation circuit allows to reduce the input bias current of the bipolar transistors of the input stage.

### Summary

It is an object of the present disclosure to provide a comparator wherein variations of the input load of the comparator as observed by the reference signal are minimized.

The present invention is defined in the appended independent claim.

The dependent claims define advantageous embodiments.

According to an aspect of the invention, a comparator device for comparing an analog signal with a reference signal is provided. The comparator device comprises a first input terminal connectable with a reference signal generator generating the reference signal, a second input terminal connectable with a signal providing device providing the analog signal, and a first comparator circuit for comparing the analog signal with the reference signal and for generating a first output signal.

The first comparator circuit comprises a first input device connected to the first input terminal for receiving the reference signal, a second input device connected with the second input terminal for receiving the analog signal, and a first output for outputting the first output signal generated by the first comparator circuit.

The comparator device according to the invention comprises a compensating device comprising i) a controlling device configured for sensing an operational parameter of the first input device and wherein a variation of the operational parameter is generating a first variation of an input load to the reference signal, and ii) a third input device connected to the first input terminal for receiving the reference signal, wherein the third input device is essentially identical to the first input device, and wherein the third input device is operable for generating a second variation of the input load to the reference signal. The controlling device is further configured for controlling the third input device such that any first variation of the input load through the first input device is cancelled out by a complementary second variation of the input load through the third input device.

Advantageously, as the third input device receives the same reference input signal as the first input device, the input load controlling device sensing the input load variations of the first input device can adjust the input load of the third input device such that the total input load to the reference signal remains constant.

Advantageously, in embodiments, the compensating device does not interfere with the comparator circuit as such and does not influence the decision mechanism in the comparator.

Advantageously, as the kickback noise is handled by the compensating device independently from the operation of the comparator circuit, the sizing and architecture of the comparator circuit can be chosen freely, allowing to optimize the overall converter performance. Examples of parameters that need to be determined in the design stage of the comparator circuit are input operational range, power consumption, mismatch decision speed and any other design parameters that may exist for a given data convertor design challenge. In contrast to for example the comparator disclosed in US9041581 which at the design stage has to be sized in a particular manner to minimize the change of load to reference voltages or kickback to such references.

Advantageously, the compensation of the input load to the reference signal works independently of the direction of signal crossings, i.e. it works both if the reference signal is initially lower or higher than the analog signal.

Advantageously, the comparator device according to the invention does not contain any feedback loops and is therefore by principle free from stability issues.

In embodiments, the operational parameter is a voltage and a variation of this voltage is resulting in a variation of a current flowing through the first input device, and wherein the controlling device is operable for controlling the third input device by increasing a current flowing through the third input device if the current flowing through the first input device is decreasing, and vice versa. In this way, the sum of the current flowing through the first input device and the current flowing through the third input device remains constant.

In embodiments, the controlling device comprises a current source configured for generating a predefined maximum current, and wherein the controlling device is generating the current flowing through the third input device as a difference between the predefined maximum current and the current flowing through the first input device.

In embodiments, the first input device and the second input device comprise respectively a first and a second CMOS transistor and a gate of the first CMOS transistor is connected with the first input for receiving the reference signal and a gate of the second transistor is connected with the second input terminal for receiving the analog signal. In these embodiments, the third input device comprises a compensating CMOS transistor having a gate connected to the first input terminal for receiving the reference signal. The operational parameter sensed by the compensating device is a drain voltage of the first transistor.

In embodiments, the controlling device is operable for controlling the third input device by increasing a drain current flowing through the compensating CMOS transistor if the drain current flowing through the first CMOS transistor of the first input device is decreasing, and vice versa, such that that the sum of the drain current flowing through the first CMOS transistor of the first input device and the drain current flowing through the compensating CMOS transistor of the third input device remains constant.

In embodiments, the first comparator circuit comprises a further current source configured for biasing the first and second transistors of respectively the first and second input device.

In embodiments, the first comparator circuit comprises a first differential amplifier wherein a first branch comprises the first input device and a second branch comprises the second input device.

In embodiments wherein the comparator circuit comprises a first differential amplifier, the first branch of the first differential amplifier comprises a third transistor connected in series with the first transistor to form a load for the first transistor, the second branch of the first differential amplifier comprise a fourth transistor connected in series with the second transistor to form a load for the second transistor, and wherein the third and fourth transistor are forming a current mirror configuration.

In embodiments, the controlling device comprises a plurality of transistors configured for mirroring the current flowing through the first transistor of the first input device and for generating the current flowing through the compensating transistor, and wherein the current flowing through the compensating transistor is generated as a complement current equal to a predefined maximum current minus the current flowing through the first transistor.

According to an aspect of the present disclosure, an analog-to-digital converter comprising a comparator device according to the invention is provided and wherein the reference signal corresponds to a ramp signal such as a single slope or a multi slope ramp signal or wherein the reference signal corresponds to a fixed reference signal.

According to a further aspect of the present disclosure, an image sensor having column parallel analog-to-digital converters is provided and wherein each of the analog-to-digital converters comprises a comparator device according to the invention. In embodiments, the image sensor corresponds to a line-scan sensor including a line of photodetectors. In other embodiments, the image sensor is a two-dimensional sensor.

### Short description of the drawings

These and further aspects of the present disclosure will be explained in greater detail by way of example and with reference to the accompanying drawings in which:
- Fig.1: schematically illustrates a comparator device according to the invention,
- Fig.2: shows a CMOS-based embodiment of a comparator device according to the invention wherein the comparator device comprises a compensating device,
- Fig.3: schematically illustrates an embodiment of a controlling device of the comparator device according to the invention,
- Fig.4: schematically illustrates an embodiment of a comparator device comprising the controlling device shown in Fig.3,
- Fig.5: schematically illustrates a further embodiment of a controlling device of the comparator device according to the invention,
- Fig.6a: schematically illustrates a further CMOS based embodiment of a comparator device according to the invention having a second comparator circuit with a second output,
- Fig.6b: schematically illustrates a further differential amplification stage having as inputs the first and second output of the comparator device shown on Fig.6a,
- Fig.7: shows, for illustrative purposes only and not being part of the invention, a bipolar transistor based embodiment of a comparator device wherein the comparator device comprises a compensating device,
- Fig.8: schematically illustrates a comparator device comprising a wide swing cascaded type differential pair,
- Fig.9: schematically shows an image sensor having column parallel analogto-digital converters comprising comparator devices according to the invention.

The drawings of the figures are neither drawn to scale nor proportioned. Generally, identical components are denoted by the same reference numerals in the figures.

### Detailed description of embodiments

The drawings described are only schematic and are non-limiting.

Use of the verb "to comprise", as well as the respective conjugations, does not exclude the presence of elements other than those stated. Use of the article "a", "an" or "the" preceding an element does not exclude the presence of a plurality of such elements.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Reference throughout this specification to "one embodiment" or "an embodiment" means that a particular feature, structure or characteristic described in connection with the embodiments is included in one or more embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one ordinary skill in the art from this disclosure, in one or more embodiments.

### Comparator device, general

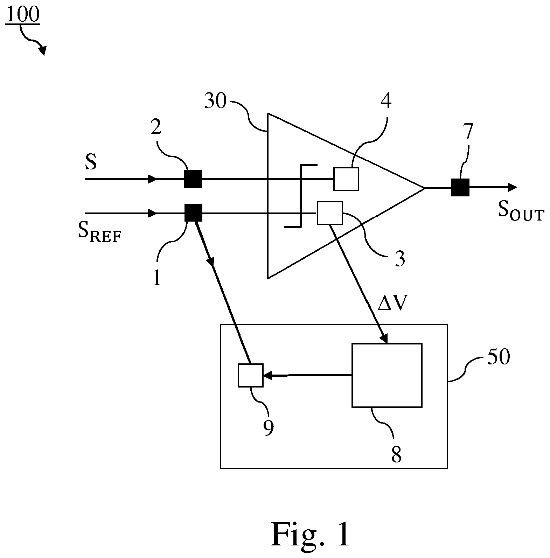

According to an aspect of the invention, a comparator device 100 for comparing an analog signal S with a reference signal S_{REF} is provided and is schematically illustrated on Fig.1.

The comparator device 100 comprises a first input terminal 1 connectable with a reference signal generator generating the reference signal S_{REF} and a second input terminal 2 connectable with a signal producing device producing the analog signal S.

The reference signal is for example a ramp signal generated by ramp generator. In embodiments, the ramp signal is a linearly increasing or decreasing voltage. In other embodiments, the reference signal is a fixed reference signal.

The first 1 and second input terminal 2 have to be construed in the broadest sense as being any element that allows to connect the external apparatuses supplying the input signals such that the comparator device can receive the input signals. An input can for example be a pin, a connector, a conductor or a portion of a conductor.

The comparator device 100 further comprises a first comparator circuit 30 for comparing the analog signal with the reference signal. The first comparator circuit 30 comprises a first input device 3 connected to the first input terminal 1 for receiving the reference signal and a second input device 4 connected with the second input terminal 2 for receiving the analog signal. The comparator circuit 30 further comprises a first output 7 for outputting an output signal S_{OUT} resulting from a comparison of the analog signal with the reference signal.

The comparator device 100 according to the invention is characterized in that it comprises a compensating device 50 and wherein the compensating device 50 comprises a third input device 9 and a controlling device 8. The controlling device 8 is connected with the first input device 3 and configured for sensing an operational parameter at the first input device 3. A variation ΔV of this operational parameter results in a first variation of an input load to the reference signal.

In embodiments, the operational parameter that is sensed by the controlling device 8 and that can influence the input load to the reference signal is for example an operational voltage of the first input device, and wherein a variation of this operational voltage is resulting in a variation of a current I1 flowing through the first input device.

The third input device 9 is connected to the first input terminal 1 for receiving the reference signal S_{REF}. Hence, both the third input device 9 as well as the first input device 3 receive the same reference signal as an input signal. The third input device is a device that is operable for generating a second variation of the input load to the reference signal.

The controlling device 8 is further connected with the third input device 9 and configured for controlling the third input device 9 such that any first variation of the input load through the first input device 3 is cancelled out by a complementary second variation of the input load through the third input device 9. In this way, the total input load to the reference signal remains constant. In other words, at any moment, a first variation of the input load at the first input device 3 is annihilated by a second variation of the input load at the third input device 9.

In embodiments, by controlling a variation of a current I_{COM} flowing through the third input device, the second variation of the input load to the reference signal can be controlled. The current I_{COM} flowing through the third input device is resulting from bias conditions imposed on the third input device.

In embodiments, the controlling device 8 is operable for controlling the third input device 9 by increasing the current I_{COM} flowing through the third input device if the current I1 flowing through the first input device is decreasing and vice versa. This controlling is performed such that the sum of the current I1 flowing through the first input device and the current I_{COM} flowing through the third input device remains constant.

The first 3, second 4 and third 9 input device have to be construed as a sensor suitable for sensing an input signal. As will be discussed in more detail below, an input device is for example a CMOS or a Bipolar transistor wherein respectively the gate or base are receiving the input signal.

A variation of an input load to the reference signal has to be construed as a variation of the input load as seen by the reference signal. In other words, the first comparator circuit 30, and especially the first input device 3 receiving the reference signal, is forming a load for the reference signal generator, named input load, and this input load, when varying, disturbs the reference signal generated by the reference signal generator. If the output impedance of the reference signal generator would be zero, then there would be no variation of the input load observed by the reference signal and hence the reference signal would not be disturbed. In practice, the output impedance of the reference generator is not zero and a parasitic capacitance is coupling the first input device with the first input terminal receiving the reference signal. As a result of this coupling, a variation of for example a bias current of the input device during operation of the comparator circuit can induce input load variations to the reference signal.

Furthermore, a variation of the input signal may cause a change of the capacitance of the reference input signal. That change in capacitance can also cause a disturbing effect to the reference signal. This is for example the case if the reference signal is a sawtooth signal which is created by charging a capacitor with a constant current. If the capacitance changes, the slope of the sawtooth signal will change. This will adversely affect the operation of the comparator circuit and the system in which it is used. For example, if the sawtooth signal and the comparator are used in an AD converter, this change in slope will adversely affect the integral non-linearity (or IDL) of the ADC.

The presentation in Fig.1 of the comparator device is a schematic and abstract representation. For example, in embodiments as will be further discussed below, besides a first differential sensing stage which amplifies and/or buffers the difference between the analog input signal and the reference input signal, one or more subsequent stages can be provided receiving as input the output of a preceding stage.

### Comparator circuits

Various embodiments of comparator devices comprising a compensating device can be provided. The comparator device according to the invention comprises at least a first comparator circuit 30. Comparator circuits are well known in the art. Only those elements of the comparator circuit necessary for understanding the invention are discussed.

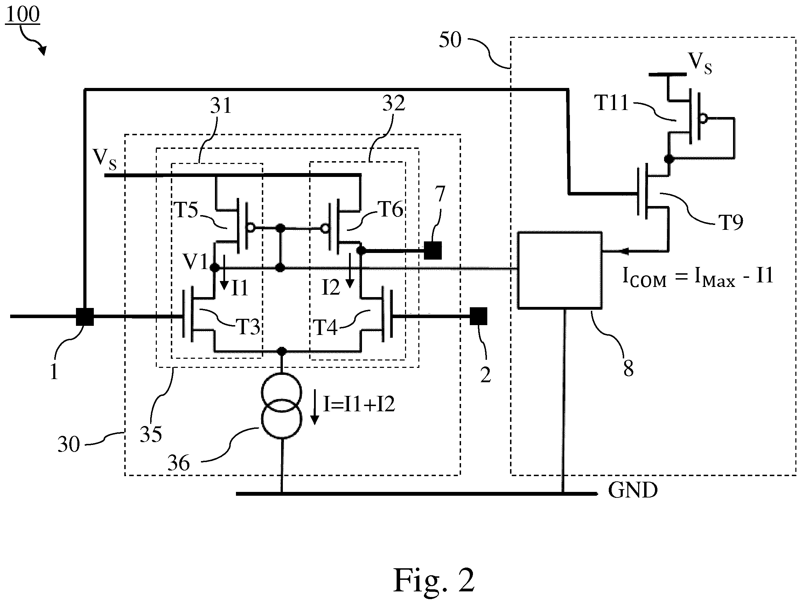

In exemplary embodiments, as shown on Fig.2, the first input device 3 and the second input device 4 of the at least first comparator circuit 30 correspond to respectively a first and a second CMOS transistor indicated with reference T3 and T4, respectively. In other embodiments the first and second input device comprise besides the first T3 and second T4 CMOS transistors other circuit components.

The comparator circuit 30 shown on Fig.2 comprises a differential amplifier 35 wherein a first branch 31 comprises the first transistor T3 forming the input device 3 and a second branch 32 comprising the second transistor T4 forming the second input device 4. In this embodiment shown on Fig.2, the first input device 3 is the first CMOS transistor T3 and the second input device 4 is the second CMOS transistor T4. As illustrated on Fig.2, the first comparator circuit 30 comprises a biasing current source 36 configured for biasing the first T3 and second T4 CMOS transistors forming the two input devices. In Fig.2, the current generated by the biasing current source is indicated by "I" and this current is split between the first branch 31 and the second branch 32 of the differential amplifier 35 and is indicated on Fig.2 as currents "11" and "I2".

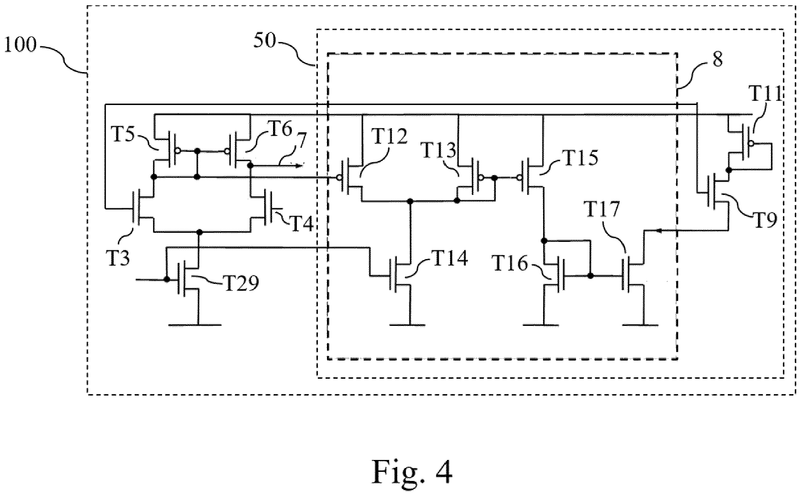

In embodiments, as shown on Fig.4, the current source 36 shown on Fig.2 is implemented, as known in the art, with an adequate transistor T29 configured as a current source.

As further shown on Fig.2, the first branch 31 and the second branch 32 of the differential amplifier 35 comprise respectively a third T5 and a fourth T6 CMOS transistor and wherein the third T5 and fourth T6 transistor are forming a current mirror configuration, known in the art. These third T5 and fourth T6 CMOS transistors are forming a load for respectively the first transistor T3 and the second transistor T4, forming the input devices for the comparator circuit 30. As shown on Fig.2, the output 7 of the first comparator circuit 30 is coupled between the second T4 and the fourth T6 transistor, more specifically between the drain of transistor T6 and the drain of transistor T4.

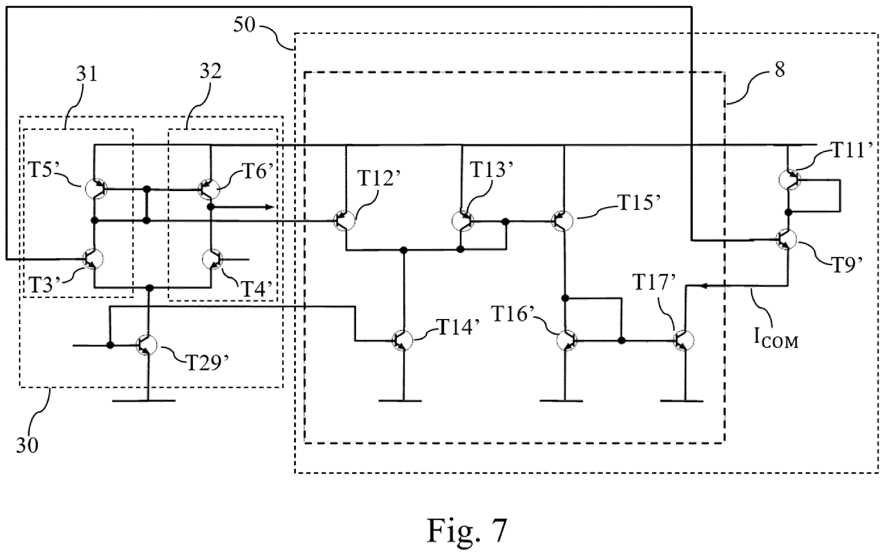

In alternative embodiments which are not part of the claims but which are only shown for illustrative purposes on Fig.7, the first comparator circuit 30 is using bipolar transistors T3',T4',T5',T6' and T29' instead of the respective CMOS transistors T3,T4,T5,T6 and T29 shown on Fig.4. Indeed, the invention is not limited to a specific semi-conductor technology or topology used for realizing the comparator device 100.

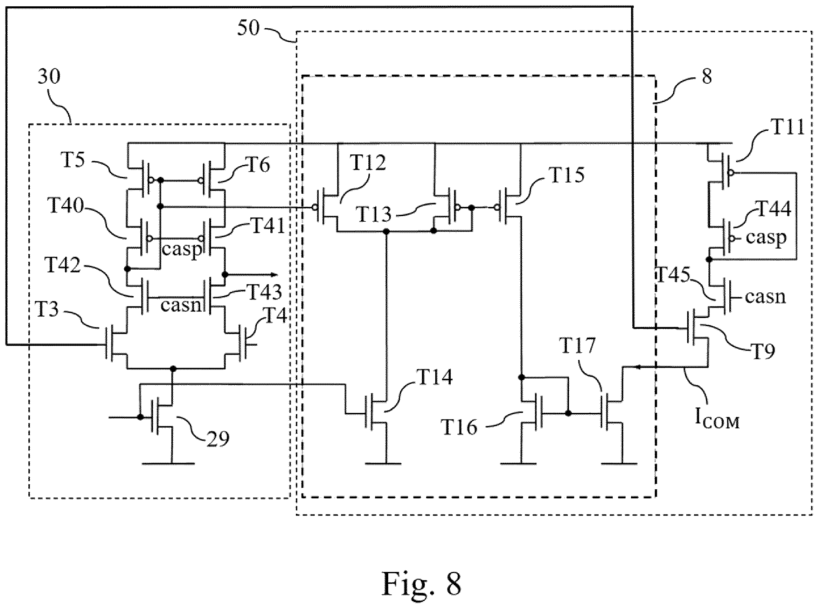

The comparator circuit of the comparator according to the invention is not limited to the specific differential pair discussed above and shown on Fig.2. In some embodiments, as for example shown on Fig.8, the differential pair is realized by means of a wide swing cascaded type of differential pair with first cascode devices formed by transistors T40 and T41 on the cascode biasvoltage casp and second cascode devices formed by transistors T42 and T43 on the cascode bias voltage casn.

### Compensating device

As discussed above and illustrated on Fig.1, the compensating device 50 comprises a third input device 9 and a controlling device 8. The controlling device 8 is on the one hand sensing an operational parameter V1 of the first input device and on the other hand is using this operational parameter as a control parameter to control the third input device 9.

In the embodiment shown on Fig.2, the parameter V1 that is sensed by the controlling device 8 is a drain voltage of the first CMOS transistor T3 forming the first input device. This drain voltage defines a drain current I1 flowing through the first CMOS transistor T3 from the drain to the source side of the transistor. Remark that as the load transistor T5 is placed in series with the first transistor T3, as shown on Fig.2, the drain current through transistor T5 is the same as the drain current through transistor T3.

In embodiments shown on Fig.2, the third input device 9 corresponds to a fifth CMOS transistor T9, further named throughout this document compensating CMOS transistor, and the variation of the drain current I_{COM} of the compensating CMOS transistor T9 is resulting in the second variation of the input load to the reference signal. Indeed, if the drain current varies, the drain voltage of the compensating CMOS transistor T9 varies and due to a parasitic capacitive coupling between the drain side of the compensating CMOS transistor T9 and the first input terminal 1 supplying the reference signal, the input load to the reference signal is varied.

In the embodiment shown in Fig.2, the controlling device 8 is compensating the first variation of the input load to the reference signal with the second variation of the input load to the reference signal by controlling the drain current of the compensating CMOS transistor T9. The drain current I_{COM} of the compensating CMOS transistor T9 is increased if the drain current I1 of the first CMOS transistor T3 of the first input device is decreasing and vice versa. For example, if the drain current I1 of the first transistor T3 of the first input device is varying with an amount ΔI then the controlling device 8 is controlling the drain current I_{COM} of the compensating transistor T9 such that it is varied by an amount -ΔI. In this way, the sum of the drain current flowing through the first CMOS transistor T3 of the first input device and the drain current flowing through the CMOS transistor T9 of the third input device remains constant. This total drain current corresponds to a value that is predefined by design. This total drain current is generally selected to be equal or larger than the maximum drain current variation that can occur in the first transistor T3 of the first input device, i.e. the maximum variation that can occur for any value of the reference signal falling within the operational range of for example a ramp reference signal and any value of an expected analog signal falling within a detectable range.

According to the invention as claimed, the third input device 9 of the first comparator circuit 30 is essentially identical to the first input device 3 of the compensating device 50. Essentially identical has to be construed as using the same components with the same characterizations for forming the third input device and the first input device.

In embodiments, the same CMOS transistors with the same operational parameters are used. For example, the CMOS transistor T9 shown on Fig.2 forming the third input device is loaded in the same way the first CMOS transistor T3 of the first input device is loaded, for example by using the same load transistors T5 and T11.

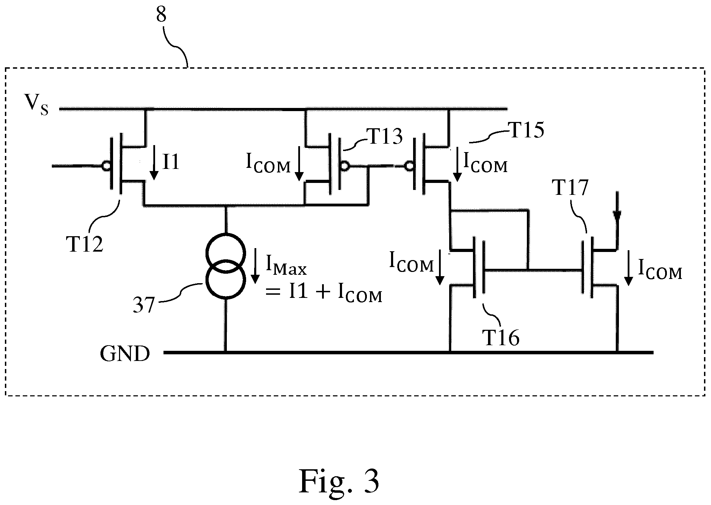

As schematically illustrated on Fig.2 and Fig.3, the compensating device 50 is powered by the same voltage supply V_{S} as the first comparator circuit 30. In other embodiments, different voltage supplies are used.

In Fig.3, an embodiment is shown of an example of a CMOS implementation of a controlling device 8, and in Fig.4, the integration of this exemplary controlling device 8 in a CMOS based comparator device 100 according to the invention is shown. The controlling device 8 comprises a current mirror transistor T12, being a CMOS transistor having a gate connected with a node located between the first transistor T3 forming the first input device and the load transistor T5, i.e. the gate voltage of transistor T12 is equal to the gate voltage of load transistor T5 of the input branch 31. In this way, the current flowing through the load transistor T5, is mirrored by the current mirror transistor T12. This current mirror transistor T12 is mounted in parallel with a diode connected MOS transistor T13, being a further CMOS transistor. As mentioned above, the current through the loading transistor T5 is the same current as the current I1 flowing through the first transistor T3, i.e. the drain current through the first CMOS transistor T3 of the first input device.

The transistors T12 and T13 shown on Fig.3 are loaded with a current provided by a current source 37 and wherein the current is equal to a maximum current Iₘₐₓ that could be sensed by the controlling device 8. As discussed above, this maximum current is to be construed as the maximum current obtainable with any possible combination of a reference signal input and an analog signal input to the comparator circuit 30. This maximum current is a predefined value based on the characterization of the first comparator circuit 30, the range of values for the reference signal and the expected range of values for the analog signal. In embodiments, the current source 37 providing current Iₘₐₓ can be the same current source as current source 36 providing current I shown on Fig.2, such that Iₘₐₓ = I.

In embodiments, as shown on Fig.4, the current source 37 shown on Fig.3 is implemented, as known in the art, with an adequate transistor T14.

The maximum current Iₘₐₓ is split between a current flowing through transistor T12 and a current flowing through transistor T13. As transistor T12 is a current mirror device with respect to the loading transistor T5, the current flowing through transistor T12 is the same as the current flowing through the loading transistor T5. As a result, the current flowing through transistor T13 is the complement current I_{com}, i.e. the maximum current Iₘₐₓ minus the current flowing through transistor T12. As illustrated on Fig.3, the complement current I_{com} is then further copied to transistor T15 and inverted to a current sink formed by the mirror pair transistors T16 and T17. As illustrated on Fig. 4, by coupling the drain side of transistor T17 with the source side of the compensating transistor T9 of the third input device, the complement current I_{com} is provided to the transistor T9, i.e. the third input device.

The transistor T9 shown on Fig.2 and Fig.4 forming the third input device is loaded with a circuitry which is identical to the loading circuitry of the first transistor T3 forming the first input device. In the embodiment shown on Fig.2 and Fig.4, the loading circuitry is a CMOS transistor T11.

By the fact that the third input device 9 is subject to the complement current passing through the first input device 3 and that its loading is equal to the loading of the first input device, its input load to the reference signal will contain the complement terms to the input load of the first input device 3. Likewise, its kick back to the input reference will be opposite and complement any kick back generated during decision taking by the first input device 3. Thus the total input load to the reference signal regardless of the combination of the reference input signal and the analog input signal, and regardless of the comparator decision state and direction, remains constant.

For some applications, it may be desirable to keep the total current consumption of a comparator constant, regardless of its decision state. Therefore, it may be desirable to add to the controller device 8 an additional circuit for keeping the total current consumption of the controller device 8 constant, i.e. independent of the value of the complement current I_{COM}.

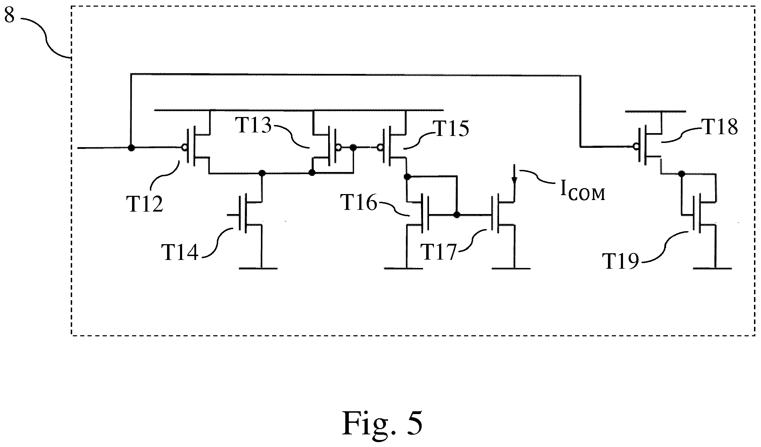

In Fig.5, an exemplary embodiment is shown of a controller device 8 comprising an additional circuit configured to keep the total current consumption constant. This additional circuit shown on Fig.5 comprises transistor T18 and T19. In order to keep the total current compensation constant, the current through transistor T12 is copied to the additional current mirror transistor T18 which is in a separate current branch drawing the required compensation current to the complement current I_{COM} from a supply voltage. For better current matching the mirror transistor T18 can be loaded with the diode connected transistor T19.

In Fig.7, for illustrative purposes only, and not being part of the invention, a controller 8 is shown that is implemented with bipolar transistor technology using bipolar transistors T12',T13',T14',T15',T16' and T17'. In this embodiment, the first input device is also realized with a bipolar transistor T9' and its load is also a bipolar transistor T11'.

For embodiments wherein the differential pair is realized by means of a wide swing cascaded type of differential pair, as shown on Fig.8, the transistor T9 forming the third input device 9 is loaded on a branch having identical cascode devices 44 and 45 connected to casp and caspn, respectively.

### Comparator device, alternative embodiments

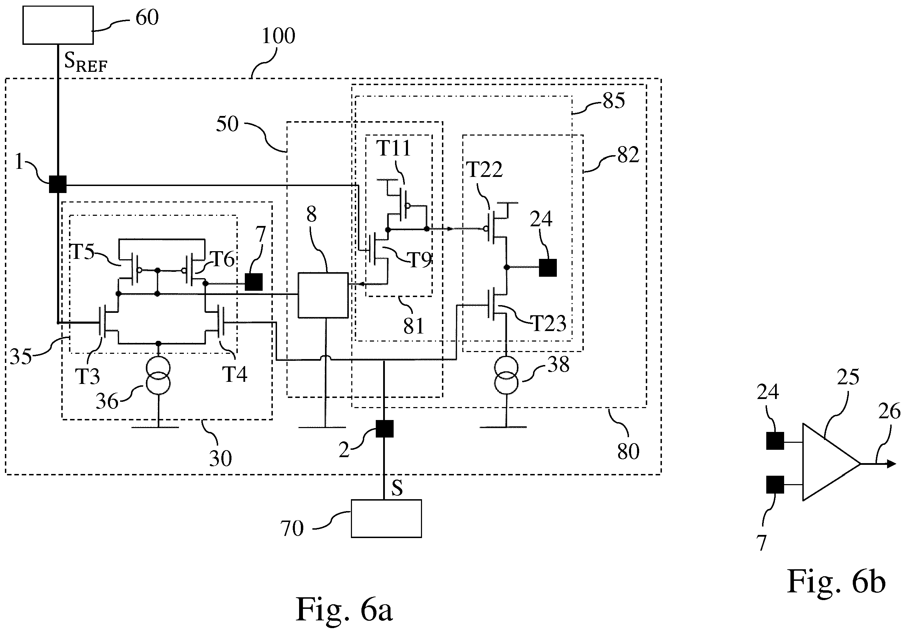

The embodiments of comparator devices according to the invention, as discussed above and illustrated for example on Fig.1 to Fig.5, are embodiments wherein the compensating device 50 is generally acting as a dummy device, in the sense that the compensating device is not influencing the output of the comparator device 100. In alternative embodiments, the compensating device 50, and more specifically the third input device 9, can be coupled with additional circuitry and provide, besides the compensating functionality discussed above, an additional functionality for the comparator device and/or for example contribute to an overall output of the comparator device. Examples of such type of embodiments are discussed below and are shown on Fig.6a and Fig.6b.

In Fig.6a, an embodiment of a comparator device 100 according to the invention is shown wherein the output of the third input device of the compensating device is used to contribute to an output of the comparator device. The comparator device shown on Fig.6a comprising besides the first comparator circuit 30 also a second comparator circuit 80 for comparing the analog signal S with the reference signal S_{REF} and for generating a second output signal at a second output 24. Indeed, as shown on Fig.6a, a fourth input device formed in this embodiment by transistor T23 is connected with the second input 2 for receiving the analog signal S, and the transistor T9 forming the third input device of the compensating device 50 is also forming an input device for the second comparator circuit 80 for receiving the reference signal S_{REF}. The fourth input device corresponds in this embodiment to a CMOS transistor T23 having its gate connected with the second input 2 for receiving the signal S. The output of the compensating transistor T9 that is forming the third input device is coupled with the gate of a transistor T22 that is coupled through it source with the drain of transistor T23. As shown on Fig.6a, the second output 24 is coupled between transistor T22 and transistor T23, more specifically between the source of transistor T22 and the drain of transistor T23. This output 24 is providing a compliment output with respect to the first output 7, i.e. if output 7 is high, output 24 is low and vice versa.

In these types of embodiments shown on Fig.6a, the compensating transistor T9 and transistor T11 can be considered as a first branch and the transistors T22 and T23 can be considered as a second branch of a second differential amplifier 85.

On Fig.6a, the reference signal generator 60 is shown providing the reference signal S_{REF} to both first input device of the first comparator circuit 30 formed by transistor T3 and the third input device of the compensating device 50 formed by transistor T9. A signal providing device 70 schematically illustrated on Fig.6a is providing the signal S to both the second input device formed by transistor T4 and the fourth input device formed by transistor T23.

In further embodiments, the comparator device comprises a further differential amplification stage 25, as shown on Fig.6b, having a first input connected with the output 7 of the first comparator circuit 30 of Fig.6a and a second input connected with the output 24 of the second comparator circuit 80 of Fig.6a.

### Applications

The invention also relates to an analog-to-digital (ADC) converter comprising a comparator device as discussed above. In these ADC embodiments, the reference signal may correspond to a single slope or multi slope ramp in the case of ramp type comparators or to a static reference signal, e.g. in the case of cyclic or successive approximation type of AD-converters.

As the comparator device discussed above is maintaining the total input load to the reference signal constant, the comparator device is especially suitable for implementation in a vector analog-to-digital system. For example, image sensors comprising column parallel analog-to-digital converters can advantageously make use of the comparator devices discussed above.

In embodiments, the image sensor is a two-dimensional image sensor, i.e. an area sensor. In other embodiments, the image sensor corresponds to a one-dimensional sensor such as a line-scan sensor including a line of photodetectors.

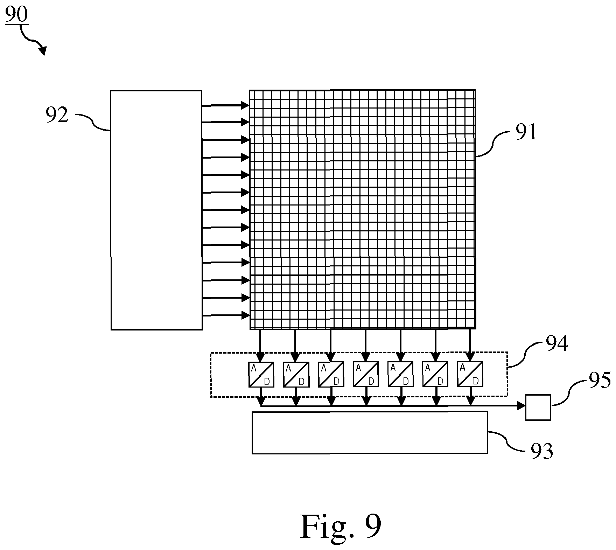

In Fig.9, an exemplary embodiment is schematically shown of an image sensor 90 having column parallel analog-to-digital converters 94 comprising comparators according to the invention as discussed above. As shown on Fig.9, the image sensor further comprises besides the column parallel ADC 94, a pixel array 91, a row addressing device 92, a column addressing device 93 and a data output device 95.

**Reference numbers**

| | |
|---|---|
| 1 | first input terminal |
| 2 | second input terminal |
| 3 | first input device |
| 4 | second input device |
| 7 | first output |
| 8 | controlling device |
| 9 | third input device |
| 23 | fourth input device |
| 24 | second output |
| 25 | further differential amplifier |
| 30 | first comparator circuit |
| 31 | first branch of first differential amplifier |
| 32 | second branch of first differential amplifier |
| 35 | first differential amplifier |
| 36 | current source for first comparator circuit |
| 37 | current source for controlling device |
| 50 | compensating device |
| 60 | reference signal generator |
| 70 | signal providing device |
| 80 | second comparator circuit |
| 90 | image sensor |
| 91 | pixel array |
| 92 | row addressing device |
| 93 | column addressing device |
| 94 | column parallel ADC |
| 95 | data output device |
| T3 to T6 | CMOS transistors of a first differential amplifier |
| T3' to T6' | bipolar transistors of a first differential amplifier |
| T9, T9' | CMOS or bipolar transistor for forming an input device for an embodiment of a compensating device |
| T11, T11' | CMOS or bipolar load transistor for transistor T9 or T9' |
| T12 to T19 | CMOS transistors of embodiments of a controlling device |
| T12' to T17' | bipolar transistors of an embodiment of a controlling device |
| T40 to T45 | cascode transistors |
| 100 | com parator device |
| 93 | column addressing device |
| 94 | column parallel ADC |
| 95 | data output device |
| T3 to T6 | CMOS transistors of a first differential amplifier |
| T3' to T6' | bipolar transistors of a first differential amplifier |
| T9, T9' | CMOS or bipolar transistor for forming an input device for an embodiment of a compensating device |
| T11, T11' | CMOS or bipolar load transistor for transistor T9 or T9' |
| T12 to T19 | CMOS transistors of embodiments of a controlling device |
| T12' to T17' | bipolar transistors of an embodiment of a controlling device |
| T40 to T45 | cascode transistors |
| 100 | comparator device |

## Claims

1. A comparator device (100) for comparing an analog signal (S) with a reference signal (SREF), comprising
• a first input terminal (1) connectable with a reference signal generator generating said reference signal (SREF),
• a second input terminal (2) connectable with a signal providing device providing said analog signal (S),
• a first comparator circuit (30) for comparing the analog signal (S) with the reference signal (S_{REF}) and for generating a first output signal (S_{OUT}), said first comparator circuit (30) comprising a first input device (3), a second input device (4), and an first output (7) for outputting the first output signal (S_{OUT}) generated by the first comparator circuit (30), and wherein said first input device (3) and said second input device (4) comprise respectively a first (T3) and a second (T4) CMOS transistor and wherein a gate of the first CMOS transistor (T3) is connected with said first input terminal (1) for receiving said reference signal (S_{REF}) and a gate of said second transistor (T4) is connected with the second input terminal (2) for receiving the analog signal (S),
wherein said comparator device (100) comprises
• a compensating device (50) comprising
i) a controlling device (8) configured for sensing an operational parameter of said first input device (3) and wherein a variation (ΔV) of said operational parameter is generating a first variation of an input load to the reference signal, wherein said operational parameter (V1) is a drain voltage of said first CMOS transistor (T3), and
ii) a third input device (9) operable for generating a second variation of the input load to the reference signal, and wherein said third input device (9) comprises a compensating CMOS transistor (T9) having a gate connected to the first input terminal (1) for receiving said reference signal (SREF),
wherein the third input device (9) is essentially identical to the first input device (3) and wherein said controlling device (8) is configured for controlling said third input device (9) such that any first variation of the input load through the first input device (3) is cancelled out by a complementary second variation of the input load through the third input device (9), and wherein the controlling device (8) is operable for increasing a drain current (I_{COM}) flowing through the compensating CMOS transistor (T9) if the drain current (11) flowing through the first CMOS transistor (T3) of the first input device is decreasing, and vice versa, such that that the sum of the drain current flowing through the first CMOS transistor (T3) of the first input device and the drain current flowing through the compensating CMOS transistor (T9) of the third input device (9) remains constant.

2. A comparator device according to claim 1, wherein said controlling device (8) comprises a current source (37) configured for generating a predefined maximum current (Iₘₐₓ), and wherein said controlling device (8) is configured for generating said drain current (I_{COM}) flowing through the compensating CMOS transistor (T9) such that I_{COM} = Iₘₐₓ - 11, wherein I_{COM} is said current flowing through the compensating CMOS transistor (T9), Iₘₐₓ is said predefined maximum current and I1 is said current flowing through said first CMOS transistor (T3) .

3. A comparator device according to claim 2, wherein said first comparator circuit (30) comprises a further current source (36) configured for biasing said first (T3) and second (T4) CMOS transistors of respectively the first (3) and second (4) input device.

4. A comparator device according to any of previous claims, wherein said first comparator circuit (30) comprises a first differential amplifier (35) wherein a first branch (31) comprises said first input device (3) and a second branch (32) comprises said second input device (4).

5. A comparator device according to claim 4, wherein said first branch (31) of the first differential amplifier (35) comprises a third transistor (T5) connected in series with said first transistor (T3) of the first input device (3) in order to form a load for said first transistor (T3), said second branch (32) of the first differential amplifier (35) comprises a fourth transistor (T9) connected in series with said second transistor (T4) of the second input device (4) in order to form a load for the second transistor (T4), and wherein said third (T5) and fourth (T6) transistor are forming a current mirror configuration.

6. A comparator device according to claim 1, wherein said controlling device (8) comprises a plurality of transistors (T12,T13,T14,T15,T16,T17, T12', T13', T14',T15', T16', T17') configured for mirroring the current (11) flowing through the first transistor (T3, T3') of the first input device (3) and for generating the current flowing through the compensating transistor (T9, T9') of the third input device (9), and wherein said current flowing through the compensating transistor (T9,T9') is generated as a complement current (I_{COM}) equal to a predefined maximum current (Iₘₐₓ) minus the current (11) flowing through the first transistor (T3, T3').

7. A comparator device according to any of previous claims, comprising a second comparator circuit (80) for comparing the analog signal (S) with the reference signal (S_{REF}) and for generating a second output signal, said second comparator circuit (80) comprises a second output (24) for outputting the second output signal generated by the second comparator circuit (80), a fourth input device (23) connected with the second input terminal (2) for receiving the analog signal (S), and wherein said third input device (9) of the compensating device (50) is forming an input device for the second comparator circuit (80) for receiving the reference signal (S_{REF}).

8. A comparator device according to claim 7, comprising a further differential amplification stage (25) having a first input connected with the first output (7) of the first comparator circuit (30) and having a second input connected with the second output (24) of the second comparator circuit (80).

9. An analog-to-digital converter comprising a comparator device according to anyone of previous claims and wherein said reference signal corresponds to a ramp signal such as a single slope or a multi slope ramp signal or wherein said reference signal corresponds to a fixed reference signal.

10. A vector analog-to-digital system comprising a plurality of comparator devices according to anyone of claims 1 to 8.

11. An image sensor (90) having column parallel analog-to-digital converters (94) and wherein each of the analog-to-digital converters comprises a comparator device according to anyone of claims 1 to 8, preferably said image sensor corresponds to a one-dimensional image sensor or to a two-dimensional image sensor.

## Patentansprüche

1. Komparatorvorrichtung (100) zum Vergleichen eines analogen Signals (S) mit einem Referenzsignal (S_{REF}), umfassend:
- einen ersten Eingangsanschluss (1), der mit einem Referenzsignalgenerator verbunden werden kann, der das Referenzsignal (S_{REF}) erzeugt,
- einen zweiten Eingangsanschluss (2), der mit einer Signalbereitstellungsvorrichtung verbunden werden kann, die das analoge Signal (S) bereitstellt,
- eine erste Komparatorschaltung (30) zum Vergleichen des analogen Signals (S) mit dem Referenzsignal (S_{REF}) und zum Erzeugen eines ersten Ausgangssignals (S_{OUT}), wobei die erste Komparatorschaltung (30) eine erste Eingangsvorrichtung (3), eine zweite Eingangsvorrichtung (4) und einen ersten Ausgang (7) zum Ausgeben des ersten Ausgangssignals (S_{OUT}), das von der ersten Komparatorschaltung (30) erzeugt wird, umfasst und wobei die erste Eingangsvorrichtung (3) und die zweite Eingangsvorrichtung (4) einen ersten (T3) beziehungsweise einen zweiten (T4) CMOS-Transistor umfassen und wobei ein Gate des ersten CMOS-Transistors (T3) mit dem ersten Eingangsanschluss (1) zum Empfangen des Referenzsignals (S_{REF}) verbunden ist und ein Gate des zweiten Transistors (T4) mit dem zweiten Eingangsanschluss (2) zum Empfangen des analogen Signals (S) verbunden ist, wobei die Komparatorvorrichtung (100) umfasst
- eine Kompensationsvorrichtung (50), umfassend
i) eine Steuervorrichtung (8), die zum Erfassen eines Betriebsparameters der ersten Eingangsvorrichtung (3) konfiguriert ist, und wobei eine Variation (ΔV) des Betriebsparameters Erzeugen einer ersten Variation einer Eingangslast zu dem Referenzsignal ist, wobei der Betriebsparameter (V1) eine Drain-Spannung des ersten CMOS-Transistors (T3) ist und
ii) eine dritte Eingangsvorrichtung (9), die zum Erzeugen einer zweiten Variation der Eingangslast zu dem Referenzsignal betreibbar ist, und wobei die dritte Eingangsvorrichtung (9) einen kompensierenden CMOS-Transistor (T9) mit einem Gate, das mit dem ersten Eingangsanschluss (1) zum Empfangen des Referenzsignals (S_{REF}) verbunden ist, umfasst,
wobei die dritte Eingangsvorrichtung (9) im Wesentlichen mit der ersten Eingangsvorrichtung (3) identisch ist
und wobei die Steuervorrichtung (8) zum Steuern der dritten Eingangsvorrichtung (9) konfiguriert ist, sodass jede erste Variation der Eingangslast durch die erste Eingangsvorrichtung (3) durch eine komplementäre zweite Variation der Eingangslast durch die dritte Eingangsvorrichtung (9) aufgehoben wird, und wobei die Steuervorrichtung (8) zum Erhöhen eines Drain-Stroms (I_{COM}), der durch den kompensierenden CMOS-Transistor (T9) fließt, betreibbar ist, wenn der Drain-Strom (I1), der durch den ersten CMOS-Transistor (T3) der ersten Eingangsvorrichtung fließt, abnimmt, und umgekehrt, sodass die Summe des Drain-Stroms, der durch den ersten CMOS-Transistor (T3) der ersten Eingangsvorrichtung fließt, und des Drain-Stroms, der durch den kompensierenden CMOS-Transistor (T9) der dritten Eingangsvorrichtung (9) fließt, konstant bleibt.

2. Komparatorvorrichtung nach Anspruch 1, wobei die Steuervorrichtung (8) eine Stromquelle (37) umfasst, die zum Erzeugen eines vordefinierten maximalen Stroms (Iₘₐₓ) konfiguriert ist, und wobei die Steuervorrichtung (8) zum Erzeugen des Drain-Stroms (I_{COM}) konfiguriert ist, der durch den kompensierenden CMOS-Transistor (T9) fließt, sodass I_{COM} = Iₘₐₓ -I1,
wobei I_{COM} der Strom ist, der durch den kompensierenden CMOS-Transistor (T9) fließt, Iₘₐₓ der vordefinierte maximale Strom ist und I1 der Strom ist, der durch den ersten CMOS-Transistor (T3) fließt.

3. Komparatorvorrichtung nach Anspruch 2, wobei die erste Komparatorschaltung (30) eine weitere Stromquelle (36) umfasst, die zum Vorspannen des ersten (T3) und zweiten (T4) CMOS-Transistors der ersten (3) beziehungsweise zweiten (4) Eingangsvorrichtung konfiguriert ist.

4. Komparatorvorrichtung nach einem der vorstehenden Ansprüche, wobei die erste Komparatorschaltung (30) einen ersten Differentialverstärker (35) umfasst, wobei eine erste Abzweigung (31) die erste Eingangsvorrichtung (3) umfasst und eine zweite Abzweigung (32) die zweite Eingangsvorrichtung (4) umfasst.

5. Komparatorvorrichtung nach Anspruch 4, wobei die erste Abzweigung (31) des ersten Differentialverstärkers (35) einen dritten Transistor (T5) umfasst, der in Reihe mit dem ersten Transistor (T3) der ersten Eingangsvorrichtung (3) verbunden ist, um eine Last für den ersten Transistor (T3) zu bilden, die zweite Abzweigung (32) des ersten Differentialverstärkers (35) einen vierten Transistor (T9) umfasst, der in Reihe mit dem zweiten Transistor (T4) der zweiten Eingangsvorrichtung (4) verbunden ist, um eine Last für den zweiten Transistor (T4) zu bilden, und wobei der dritte (T5) und vierte (T6) Transistor eine Stromspiegelkonfiguration bilden.

6. Komparatorvorrichtung nach Anspruch 1, wobei die Steuervorrichtung (8) mehrere Transistoren (T12, T13, T14, T15, T16, T17, T12', T13', T14', T15', T16', T17') umfasst, die konfiguriert sind, den Strom (I1), der durch den ersten Transistor (T3, T3') der ersten Eingangsvorrichtung (3) fließt, zu spiegeln und den Strom, der durch den kompensierenden Transistor (T9, T9') der dritten Eingangsvorrichtung (9) fließt, zu erzeugen, und wobei der Strom, der durch den kompensierenden Transistor (T9, T9') fließt, als ein Komplementstrom (I_{COM}) erzeugt wird, gleich einem vordefinierten maximalen Strom (Iₘₐₓ) minus dem Strom (I1), der durch den ersten Transistor (T3, T3') fließt.

7. Komparatorvorrichtung nach einem der vorstehenden Ansprüche, umfassend eine zweite Komparatorschaltung (80) zum Vergleichen des analogen Signals (S) mit dem Referenzsignal (S_{REF}) und zum Erzeugen eines zweiten Ausgangssignals, wobei die zweite Komparatorschaltung (80) einen zweiten Ausgang (24)zum Ausgeben des zweiten Ausgangssignals umfasst, das von der zweiten Komparatorschaltung (80) erzeugt wird, wobei eine vierte Eingangsvorrichtung (23) mit dem zweiten Eingangsanschluss (2) zum Empfangen des analogen Signals (S) verbunden ist, und wobei die dritte Eingangsvorrichtung (9) der Kompensationsvorrichtung (50) eine Eingangsvorrichtung für die zweite Komparatorschaltung (80) zum Empfangen des Referenzsignals (S_{REF}) bildet.

8. Komparatorvorrichtung nach Anspruch 7, umfassend eine weitere Differentialverstärkerstufe (25) mit einem ersten Eingang, der mit dem ersten Ausgang (7) der ersten Komparatorschaltung (30) verbunden ist, und mit einem zweiten Eingang, der mit dem zweiten Ausgang (24) der zweiten Komparatorschaltung (80) verbunden ist.

9. Analog/Digital-Wandler, umfassend eine Komparatorvorrichtung nach einem der vorstehenden Ansprüche, und wobei das Referenzsignal einem Rampensignal entspricht, wie einem Einzelflanken- oder einem Mehrfachflanken-Rampensignal, oder wobei das Referenzsignal einem festgesetzten Referenzsignal entspricht.

10. Vektor-Analog/Digital-System, umfassend mehrere Komparatorvorrichtungen nach einem der Ansprüche 1 bis 8.

11. Bildsensor (90) mit spaltenparallelen Analog/Digital-Wandlern (94) und wobei jeder der Analog/DigitalWandler eine Komparatorvorrichtung nach einem der Ansprüche 1 bis 8 umfasst, wobei der Bildsensor vorzugsweise einem eindimensionalen Bildsensor oder einem zweidimensionalen Bildsensor entspricht.

## Revendications

1. Dispositif comparateur (100) pour comparer un signal analogique (S) à un signal de référence (S_{REF}), comprenant
• une première borne d'entrée (1) pouvant être reliée à un générateur de signal de référence produisant ledit signal de référence (S_{REF}),
• une seconde borne d'entrée (2) pouvant être reliée à un dispositif de fourniture de signal fournissant ledit signal analogique (S),
• un premier circuit comparateur (30) pour comparer le signal analogique (S) au signal de référence (S_{REF}) et pour produire un premier signal de sortie (S_{OUT}), ledit premier circuit comparateur (30) comprenant un premier dispositif d'entrée (3), un deuxième dispositif d'entrée (4) et une première sortie (7) pour sortir le premier signal de sortie (S_{OUT}) produit par le premier circuit comparateur (30), et dans lequel ledit premier dispositif d'entrée (3) et ledit deuxième dispositif d'entrée (4) comprennent respectivement un premier (T3) et un deuxième (T4) transistor CMOS et dans lequel une grille du premier transistor CMOS (T3) est reliée à ladite première borne d'entrée (1) pour recevoir ledit signal de référence (S_{REF}) et une grille dudit deuxième transistor (T4) est reliée à la seconde borne d'entrée (2) pour recevoir le signal analogique (S),
dans lequel ledit dispositif comparateur (100) comprend
• un dispositif de compensation (50) comprenant
i) un dispositif de commande (8) configuré pour détecter un paramètre opérationnel dudit premier dispositif d'entrée (3) et dans lequel une variation (ΔV) dudit paramètre opérationnel produit une première variation d'une charge d'entrée au signal de référence, dans lequel ledit paramètre opérationnel (V1) est une tension de drain dudit premier transistor CMOS (T3), et
ii) un troisième dispositif d'entrée (9) pouvant être mis en œuvre pour produire une seconde variation de la charge d'entrée au signal de référence et dans lequel ledit troisième dispositif d'entrée (9) comprend un transistor CMOS de compensation (T9) ayant une grille reliée à la première borne d'entrée (1) pour recevoir ledit signal de référence (S_{REF}),
dans lequel le troisième dispositif d'entrée (9) est sensiblement identique au premier dispositif d'entrée (3)
et dans lequel ledit dispositif de commande (8) est configuré pour commander ledit troisième dispositif d'entrée (9) de sorte que toute première variation de la charge d'entrée à travers le premier dispositif d'entrée (3) est neutralisée par une seconde variation complémentaire de la charge d'entrée à travers le troisième dispositif d'entrée (9), et dans lequel le dispositif de commande (8) peut être mis en œuvre pour augmenter un courant de drain (I_{COM}) s'écoulant à travers le transistor CMOS de compensation (T9) si le courant de drain (I1) s'écoulant à travers le premier transistor CMOS (T3) du premier dispositif d'entrée diminue, et vice versa, de sorte que la somme du courant de drain s'écoulant à travers le premier transistor CMOS (T3) du premier dispositif d'entrée et du courant de drain s'écoulant à travers le transistor CMOS de compensation (T9) du troisième dispositif d'entrée (9) reste constante.

2. Dispositif comparateur selon la revendication 1, dans lequel ledit dispositif de commande (8) comprend une source de courant (37) configurée pour produire un courant maximal prédéfini (Iₘₐₓ) et dans lequel ledit dispositif de commande (8) est configuré pour produire ledit courant de drain (I_{COM}) s'écoulant à travers le transistor CMOS de compensation (T9) de sorte que I_{COM} = Iₘₐₓ - I1, dans lequel I_{COM} est ledit courant s'écoulant à travers le transistor CMOS de compensation (T9), Iₘₐₓ est ledit courant maximal prédéfini et I1 est ledit courant s'écoulant à travers ledit premier transistor CMOS (T3).

3. Dispositif comparateur selon la revendication 2, dans lequel ledit premier circuit comparateur (30) comprend une source de courant supplémentaire (36) configurée pour polariser lesdits premier (T3) et deuxième (T4) transistors CMOS respectivement des premier (3) et deuxième (4) dispositifs d'entrée.

4. Dispositif comparateur selon l'une quelconque des revendications précédentes, dans lequel ledit premier circuit comparateur (30) comprend un premier amplificateur différentiel (35) dans lequel une première branche (31) comprend ledit premier dispositif d'entrée (3) et une seconde branche (32) comprend ledit deuxième dispositif d'entrée (4).

5. Dispositif comparateur selon la revendication 4, dans lequel ladite première branche (31) du premier amplificateur différentiel (35) comprend un troisième transistor (T5) relié en série audit premier transistor (T3) du premier dispositif d'entrée (3) afin de former une charge pour ledit premier transistor (T3), ladite seconde branche (32) du premier amplificateur différentiel (35) comprend un quatrième transistor (T9) relié en série audit deuxième transistor (T4) du deuxième dispositif d'entrée (4) afin de former une charge pour le deuxième transistor (T4), et dans lequel lesdits troisième (T5) et quatrième (T6) transistors forment une configuration de miroir de courant.

6. Dispositif comparateur selon la revendication 1, dans lequel ledit dispositif de commande (8) comprend une pluralité de transistors (T12, T13, T14, T15, T16, T17, T12', T13', T14', T15', T16', T17') configurés pour **refléter** le courant (I1) s'écoulant à travers le premier transistor (T3, T3') du premier dispositif d'entrée (3) et pour produire le courant s'écoulant à travers le transistor de compensation (T9, T9') du troisième dispositif d'entrée (9), et dans lequel ledit courant s'écoulant à travers le transistor de compensation (T9, T9') est produit comme un courant de complément (I_{COM}) égal à un courant maximal prédéfini (Iₘₐₓ) moins le courant (I1) s'écoulant à travers le premier transistor (T3, T3').

7. Dispositif comparateur selon l'une quelconque des revendications précédentes, comprenant un second circuit comparateur (80) pour comparer le signal analogique (S) au signal de référence (S_{REF}) et pour produire un second signal de sortie, ledit second circuit comparateur (80) comprend une seconde sortie (24) pour sortir le second signal de sortie produit par le second circuit comparateur (80), un quatrième dispositif d'entrée (23) relié à la seconde borne d'entrée (2) pour recevoir le signal analogique (S), et dans lequel ledit troisième dispositif d'entrée (9) du dispositif de compensation (50) forme un dispositif d'entrée pour le second circuit comparateur (80) pour recevoir le signal de référence (S_{REF}).

8. Dispositif comparateur selon la revendication 7, comprenant un étage d'amplification différentielle supplémentaire (25) ayant une première entrée reliée à la première sortie (7) du premier circuit comparateur (30) et ayant une seconde entrée reliée à la seconde sortie (24) du second circuit comparateur (80).

9. Convertisseur analogique-numérique comprenant un dispositif comparateur selon l'une quelconque des revendications précédentes et dans lequel ledit signal de référence correspond à un signal de rampe comme un signal de rampe à pente unique ou à pente multiple ou dans lequel ledit signal de référence correspond à un signal de référence fixe.

10. Système analogique-numérique vectoriel comprenant une pluralité de dispositifs comparateurs selon l'une quelconque des revendications 1 à 8.

11. Capteur d'image (90) ayant des convertisseurs analogique-numérique parallèles en colonne (94) et dans lequel chacun des convertisseurs analogique-numérique comprend un dispositif comparateur selon l'une quelconque des revendications 1 à 8, de préférence ledit capteur d'image correspond à un capteur d'image unidimensionnel ou à un capteur d'image bidimensionnel.
